# EUROPEAN PATENT APPLICATION

(11) **EP 2 873 749 A2**
(43) Date of publication of application: **20.05.2015**
(21) Application number: 14178352.2
(22) Date of filing: 24.07.2014
(51) Int. Cl.: C23C 14/04, C23C 14/28, H01L 51/56

(54) **Mask and method of forming continuous layer**

(30) Priority: 14.11.2013 KR 20130138294
(71) Applicant: Samsung Display Co., Ltd., Yongin-City, Gyeonggi-Do, 446-711 (KR)
(72) Inventor: Lee, Yeon Hwa, Gyeonggi-do (KR); Bang, Hyun Sung, Gyeonggi-do (KR); Lee, Joon Gu, Seoul (KR); Choung, Ji Young, Gyeonggi-do (KR); Choi, Jin Baek, Gyeonggi-do (KR); Hwang, Kyu Hwan, Gyeonggi-do (KR); Song, Young Woo, Gyeonggi-do (KR)
(74) Representative: Walaski, Jan Filip

(57) **Abstract**

A mask for forming a layer, a method of forming a layer, and a manufacturing method of an organic light-emitting diode (OLED) display are disclosed. In one aspect, the mask includes at least one light absorption portion and at least one reflection portion that are formed in a unit region, the unit region corresponding to a region where a continuous layer is formed, wherein the light absorption portion and the reflection portion in the unit region are formed at different areas from each other.

## Description

The described technology generally relates to a mask for forming a layer, a method of forming a layer, and a manufacturing method of an organic light-emitting diode (OLED) display.

Displays, such as a liquid crystal display (LCD), an organic light-emitting diode (OLED) display, and an electrophoretic display, include a field generating electrode and an electro-optical active layer. The LCD includes a liquid crystal layer as the electro-optical active layer. The OLED display includes an organic light-emitting layer as the electro-optical active layer. The electrophoretic display includes charged particles. The field generating electrode receives a data signal by being connected to a switching element such as a thin film transistor, and the electro-optical active layer displays an image by converting the data signal into an optical signal.

Among the above-mentioned display devices, an OLED device is self-emissive and thus does not require a separate light source. OLED displays have favorable characteristics such as lower power consumption, a fast response speed, a wide viewing angle, and a good contrast ratio.

The OLED device includes a plurality of pixels such as a red pixel, a blue pixel, and a green pixel. Other colors can be displayed by combining the pixels. Each pixel includes an organic light-emitting element and a plurality of thin film transistors to drive the pixel.

The organic light-emitting element includes a pixel electrode and a common electrode as the field generating electrodes, and an emission member formed between two electrodes. One of the pixel electrode and the common electrode is an anode and the other electrode is a cathode. An electron injected from the cathode and a hole injected from the anode are combined in the light-emitting layer to form an exciton, which emits light while discharging energy. The emission member can include an organic material.

A manufacturing process of various electronic devices and the display device includes a process of forming a plurality of layer patterns on a substrate. The layer patterns can be formed by various methods such as inkjet printing, screen printing, and photolithography.

Organic material is very sensitive to air and water such that a general lithography method used in forming an inorganic layer pattern, particularly a photolithography method, cannot be used. Instead, the organic layer pattern can be formed through a printing process such as an inkjet process, a spinning process, a nozzle process, a deposition and patterning process, a deposition process using a shadow mask, and a transferring process using heat or laser.

As described above, among the several methods of forming the layer having the pattern, the transferring process is used as a method of forming the layer pattern on a large-sized substrate with low cost and simplicity.

One inventive aspect is a mask having a uniform thickness formed through a transferring process, and a method of forming a layer.

Another aspect is a manufacturing method of an organic light-emitting diode (OLED) display using a mask for forming a layer having a uniform thickness formed through a transferring process.

Another aspect is a mask for forming a layer which includes at least one light absorption portion and at least one reflection portion that are positioned in a unit region, the unit region corresponding to a region where a continuous layer is formed, wherein the light absorption portion and the reflection portion in the unit region are positioned at different areas from each other.

Another aspect is a method of forming a layer which includes: depositing a deposition material on a mask for forming a layer including at least one light absorption portion and at least one reflection portion that are positioned in a unit region corresponding to a region where a continuous layer is formed, wherein the light absorption portion and the reflection portion of the unit region are positioned at different areas from each other; aligning the mask and an object substrate; and irradiating light to a rear surface of the mask to heat the light absorption portion.

Another aspect is a manufacturing method of an organic light-emitting diode (OLED) display which includes: depositing a deposition material on a mask for forming a layer including at least one light absorption portion and at least one reflection portion that are positioned in a unit region corresponding to a region where a continuous layer is formed, wherein the light absorption portion and the reflection portion of the unit region are positioned at different areas from each other; aligning the mask and an object substrate; and irradiating light to a rear surface of the mask to heat the light absorption portion.

The light absorption portion and the reflection portion may be alternately disposed in at least one direction of a first direction and a second direction different from the first direction in the unit region.

A substrate, at least one light absorption layer positioned on the substrate and forming the light absorption portion, and at least one reflection layer positioned on the substrate and forming the reflection portion may be further included.

The light absorption layer or the reflection layer positioned at an inclination region positioned at an edge of the unit region may be inclined upwardly with respect to a surface of the substrate.

An inclination angle of the light absorption layer or the reflection layer with the surface of the substrate in the inclination region may be in a range of about 40 degrees to about 50 degrees.

A width of the inclination region may be equal to or less than a width of the light absorption portion or the reflection portion.

An insertion layer positioned between the reflection layer and the light absorption layer in the inclination region and the substrate may be further included, and an upper surface of the insertion layer may form an inclined surface.

The reflection layer and the light absorption layer may be positioned at a same layer and may not overlap each other.

The reflection layer and the light absorption layer may be positioned at different layers, and the light absorption layer may include a portion overlapping the reflection layer.

At least one of the light absorption portion and the reflection portion may be substantially quadrangular.

At least one of the light absorption portion and the reflection portion positioned at an edge region positioned at an edge of the unit region may be approximately rectangular including a short side and a long side that is longer than the short side, and at least one of the light absorption portion and the reflection portion positioned at a center region enclosed by the edge region in the unit region may be approximately square.

A substrate, at least one light absorption layer positioned on the substrate and forming the light absorption portion and at least one reflection layer positioned on the substrate and forming the reflection portion may be further included, wherein the light absorption layer or the reflection layer positioned at an inclination region positioned at an edge of the unit region may be inclined upwardly with respect to a surface of the substrate, and a length of the short side of the light absorption portion or the reflection portion positioned at the edge region may be substantially the same as a width of the inclination region.

At least one of the light absorption portion and the reflection portion may have a belt shape enclosing a center of the unit region.

One of the light absorption portion and the reflection portion may be positioned at a center of the unit region, and the light absorption portion or the reflection portion positioned at the center of the unit region may be substantially polygonal.

A width of the light absorption portion or the reflection portion positioned at an outermost area of the unit region may be larger than a width of the light absorption portion or the reflection portion positioned inside the outermost area.

A light absorption portion of the at least one light absorption portion may be positioned at a center of the unit region, and another light absorption portion separated from the light absorption portion positioned at the center may be positioned near the center of the unit region.

The light absorption portion positioned near the center of the unit region may be positioned near a corner of the unit region.

A substrate, at least one light absorption layer positioned on the substrate and forming the light absorption portion, and at least one reflection layer positioned on the substrate and forming the reflection portion may be further included, wherein the light absorption layer or the reflection layer positioned at an inclination region positioned at an edge of the unit region may be inclined upwardly with respect to a surface of the substrate, and an inner boundary of the inclination region may be approximately aligned to an edge boundary of the light absorption portion positioned near the center of the unit region.

The layer thickness formed by a transferring process using the mask according to an exemplary embodiment can be uniform.

Another aspect is a mask for forming a layer, comprising at least one light absorption portion formed in a first area of a unit region of the mask and at least one light reflection portion formed in a second area of the unit region of the mask. The second area is different from the first area, and the unit region corresponds to a region where a continuous layer is formed.

In the above mask, the light absorption portion and the reflection portion are alternately formed in at least one of two different directions. The above mask further comprises a substrate and at least one layer formed over the substrate having the light absorption portion and the light reflection portion. In the above mask, the light absorption portion or light reflection portion of the layer is inclined upwardly with respect to a surface of the substrate at an edge of the unit region. In the above mask, an inclination angle of the layer is in a range of about 40 degrees to about 50 degrees.

In the above mask, the width of the inclined region is substantially equal to or less than the width of the light absorption portion or light reflection portion. The above mask further comprises an insertion layer formed between the edge of the unit region and the substrate, wherein a surface of the insertion layer is inclined with respect to the substrate. In the above mask, the light reflection layer and the light absorption layer are formed in the same layer and do not overlap each other. In the above mask, the light reflection layer and the light absorption layer are formed in different layers, and the light absorption layer includes a portion at least partially overlapping the reflection layer.

In the above mask, at least one of the light absorption portion or the light reflection portion is substantially quadrangular. In the above mask, the substantially quadrangular portion is substantially rectangular, includes a short side and a long side that is longer than the short side, and has a substantially square shape at a center region enclosed by the edge region in the unit region. The above mask further comprises a substrate, at least one light absorption layer formed over the substrate so as to form the light absorption portion, and at least one reflection layer formed over the substrate so as to form the light reflection portion. In the above mask, the light absorption or reflection layer is inclined upwardly with respect to a surface of the substrate at an edge of the unit region, and the length of a short side of the light absorption portion or the light reflection portion is substantially the same as the width of the inclined portion.

In the above mask, at least one of the light absorption portion or the light reflection portion has a substantially belt shape enclosing the center of the unit region. In the above mask, one of the light absorption portion and the reflection portion is formed at the center of the unit region and is substantially polygonal. In the above mask, the width of the light absorption or reflection portion formed at an outermost area of the unit region is larger than the width of the light absorption or reflection portion formed inside the outermost area. In the above mask, the light absorption portion comprises a first light absorption portion formed at the center of the unit region, and a second light absorption portion separated from the first light absorption portion.

In the above mask, the second light absorption portion is positioned adjacent to a corner of the unit region. The above mask further comprises a substrate, at least one light absorption layer formed over the substrate so as to form the light absorption portion, and at least one light reflection layer formed over the substrate so as to form the reflection portion. In the above mask, the light absorption or reflection layer is inclined upwardly with respect to a surface of the substrate at an edge of the unit region, and an inner boundary of the inclined portion is aligned with an edge boundary of the light absorption portion positioned near the center of the unit region.

Another aspect is a method of forming a layer, comprising depositing a deposition material on a mask, substantially aligning the mask with an object substrate, and irradiating light towards a rear surface of the mask so that the light absorption portion is heated. The mask comprises at least one light absorption portion formed in a first area of a unit region of the mask and at least one light reflection portion formed in a second area of the unit region of the mask. The second area is different from the first area, and the unit region corresponds to a region where a continuous layer is configured to be formed

In the above method, the light absorption portion and the reflection portion are alternately formed in at least one of two different directions. In the above method, the light absorption or reflection portion is inclined upwardly with respect to a surface of the substrate at an edge of the unit region. In the above method, at least one of the light absorption or reflection portion is substantially quadrangular. In the above method, at least one of the light absorption or reflection portion has a substantially belt shape enclosing the center of the unit region.

In the above method, the light absorption portion comprise a first light absorption portion formed at the center of the unit region, and a second light absorption portion separated from the first light absorption portion and formed adjacent to the center of the unit region.

Another aspect is a method of manufacturing an organic light-emitting diode (OLED) display, comprising depositing a deposition material on a mask, substantially aligning the mask with an object substrate, and irradiating light towards a rear surface of the mask so that the light absorption portion is heated. The mask comprises at least one light absorption portion formed in a first area of a unit region of the mask, and at least one light reflection portion formed in a second area of the unit region of the mask. The second area is different from the first area, and the unit region corresponds to a region where a continuous organic light-emitting layer is configured to be formed.

In the above method, the light absorption portion and the reflection portion are alternately formed in at least one of two different directions. In the above method, the light absorption or reflection portion is inclined upwardly with respect to a surface of the substrate at an edge of the unit region. In the above method, at least one of the light absorption or reflection portion is substantially quadrangular. In the above method, at least one of the light absorption or reflection portion has a substantially belt shape enclosing the center of the unit region. In the above method, the light absorption portion comprises a first light absorption portion formed at the center of the unit region, and a second light absorption portion separated from the first light absorption portion.

Another aspect is a mask for forming a layer, comprising a plurality of light absorption portions formed in a first area of a unit region of the mask, and a plurality of light reflection portions formed in a second area of the unit region of the mask. The light reflection portions are alternately formed with respect to the light absorption portions, and the unit region corresponds to a region where a continuous layer is formed.

By manufacturing the organic light-emitting diode display through the transferring process using the mask according to an exemplary embodiment, the emission member of the uniform thickness can be formed in each pixel.

Embodiments of the invention will now be described by way of example, with reference to the accompanying drawings, in which:
FIG. 1 and FIG. 2 are top plan views of a mask for forming a layer according to an exemplary embodiment.
FIG. 3 is a cross-sectional view of the mask for forming the layer of FIG. 1 taken along the line III-III.
FIG. 4 is a cross-sectional view of a process of forming a layer on an object substrate by using the mask for forming the layer shown in FIG. 3.
FIG. 5 is a simulation graph of a thickness at a position of a layer formed by using a mask for forming a layer according to an exemplary embodiment.
FIG. 6 is a cross-sectional view of a mask for forming a layer according to an exemplary embodiment.
FIG. 7 is a cross-sectional view of a process of forming a layer on an object substrate by using a mask for forming a layer shown in FIG. 6.
FIG. 8 is a top plan view of a mask for forming a layer according to an exemplary embodiment.
FIG. 9 is a cross-sectional view of the mask for forming a layer shown in FIG. 8 taken along the line IX-IX.
FIG. 10 is a perspective view of the mask for forming a layer and the object substrate shown in FIG. 8.
FIG. 11 is a cross-sectional view of a process of forming a layer on an object substrate by using a mask for forming a layer shown in FIG. 9.
FIG. 12 is a simulation result of a thickness of a layer formed by using a mask for forming a layer shown in FIG. 8.
FIG. 13 is another cross-sectional view of a mask for forming a layer of FIG. 8 taken along the line IX-IX.
FIG. 14 is a cross-sectional view of a process of forming a layer on an object substrate by using a mask for forming a layer shown in FIG. 13.
FIG. 15 and FIG. 16 are layout views of a plurality of pixels included in a display device according to an exemplary embodiment.
FIG. 17 is a cross-sectional view of a display device according to an exemplary embodiment.
FIG. 18 is a top plan view of a mask for forming a layer according to an exemplary embodiment.
FIG. 19 is a cross-sectional view of a mask for forming a layer of FIG. 18 taken along the line XIX-XIX.
FIG. 20 is a simulation result of a thickness of a layer formed by using a mask for forming a layer shown in FIG. 18.
FIG. 21 is a top plan view of a mask for forming a layer according to an exemplary embodiment.
FIG. 22 is a simulation result of a thickness of a layer formed by using a mask for forming a layer shown in FIG. 21.
FIG. 23 is a top plan view of a mask for forming a layer according to an exemplary embodiment.
FIG. 24 is a simulation result of a thickness of a layer formed by using a mask for forming a layer shown in FIG. 23.
FIG. 25 is a top plan view of a mask for forming a layer according to an exemplary embodiment.

In an exemplary embodiment, a mask 1 includes at least one light absorption portion P and at least one reflection portion R positioned in a unit region TA (also referred to as a mask region) corresponding to a region where a continuous layer (e.g., an organic light-emitting layer) is to be formed on an object substrate. The light absorption portion P and the reflection portion R positioned in the unit region TA are formed at different areas. Shapes of the light absorption portion P and the reflection portion R of the unit region TA can vary.

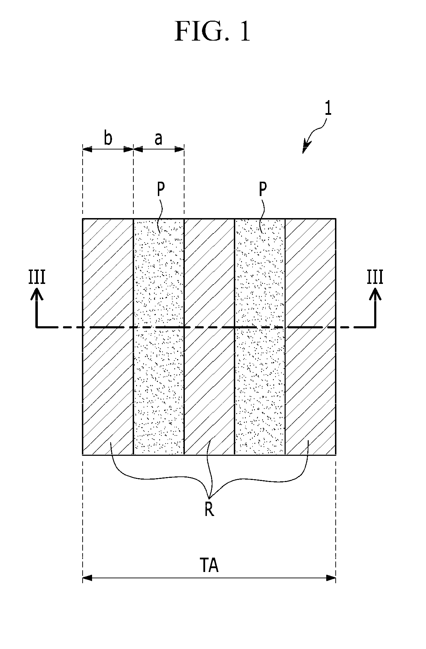

Firstly, the mask 1 according to an exemplary embodiment will be described with reference to FIG. 1 to FIG. 5.

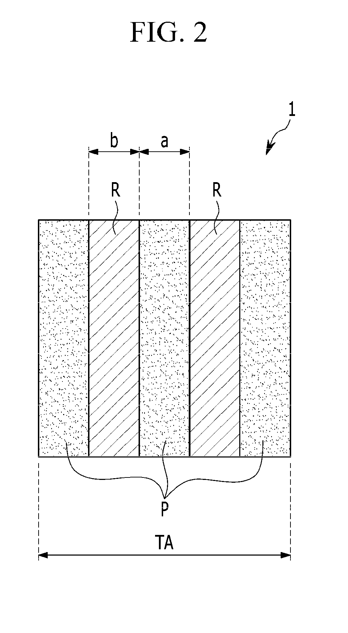

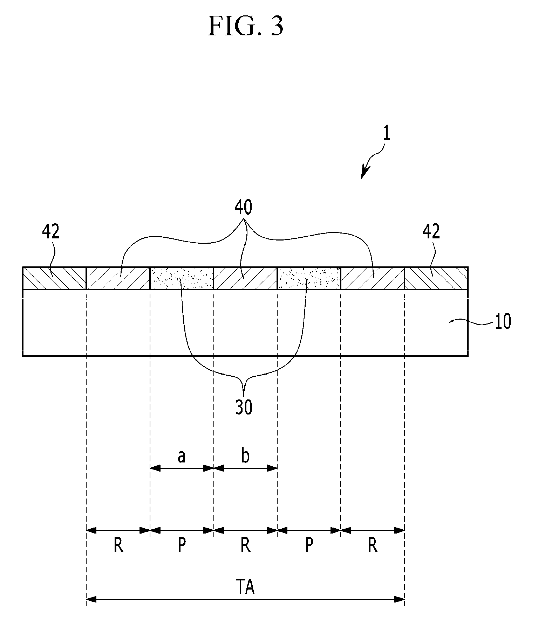

FIG. 1 and FIG. 2 are top plan views of the mask 1, and FIG. 3 is a cross-sectional view of the mask 1 of FIG. 1 taken along the line III-III.

Referring to FIG. 1 or FIG. 2, the mask 1 according to an exemplary embodiment includes at least one light absorption portion P and at least one reflection portion R that are alternately arranged in at least one direction and are positioned in the unit region TA. In some embodiments, a plurality of light absorption portions P that are separated from each other in one direction corresponding to one unit region TA are formed.

The layer that is formed in a region corresponding to the unit region TA can be continuously formed. The length of one side of the unit region TA can be from several micrometers to several hundred micrometers, but is not limited thereto.

FIG. 1 and FIG. 2 show a plurality of light absorption portions P and a plurality of reflection portions R that are alternately arranged, for example, horizontally. FIG. 1 shows an example that the reflection portions R are formed at an edge of the unit region TA, and FIG. 2 is an example of the light absorption portions P formed at the edge of the unit region TA. However, the method of alternately arranging the light absorption portions P and the reflection portions R is not limited thereto.

The width a of the light absorption portions P can be in the range of several micrometers, for example, from about 2 µm to about 5 µm, but is not limited thereto. The width b of the reflection portions R can be in a range of several micrometers, for example, from about 2 µm to about 5 µm, but is not limited thereto.

Referring to FIG. 3, the light absorption portion P and the reflection portion R can be respectively formed by a light absorption layer 30 and a reflection layer 40 that are alternately formed on a substrate 10. The light absorption layer 30 and the reflection layer 40 can be formed in the same layer.

The substrate 10 can be at least partially transparent such that light can be at least partially transmitted. The substrate 10 can be formed of a polymer material such as polyester, polyacryl, polyepoxy, polyethylene, polystyrene, polyethylene terephthalate, or glass.

The light absorption layer 30, which has low reflectivity, at least partially absorbs light and converts it into heat energy. The light absorption layer 30 can include a material having an optical density and a light absorbing property. For example, the light absorption layer 30 can be formed of at least one of a metal such as molybdenum (Mo), titanium (Ti), tantalum (Ta), tungsten (W), chromium (Cr), aluminum (Al), oxides, sulfides thereof, alloys thereof, carbon black, graphite, or a polymer including an infrared ray dye as the light absorbing material.

The light absorption layer 30 can be made of a single layer or a multilayer. The single layer can be formed of the above described material. The multilayer can include a structure in which a metal layer and a metal oxide are alternately deposited. In the case of the multilayered structure, the metal oxide can include a transparent metal oxide such as ITO, TCO, or TiO₂. The multilayer can further include a passivation layer including a silicon oxide (SiOₓ), a silicon nitride (SiNₓ), or a titanium oxide (TiOₓ) adjacent to the metal layer.

The reflection layer 40 includes a material having high reflectance. For example, the reflection layer 40 can include at least one of aluminum (Al), silver (Ag), gold (Au), or alloys thereof.

The light absorption layer 30 and the reflection layer 40 can be deposited by a method such as sputtering, deposition, and plating, and can be patterned by using a patterning method such as photolithography.

Referring to FIG. 3, a periphery (peripheral) reflection layer 42 can be formed in an outer region of the unit region TA. The periphery reflection layer 42 can also include the material having high reflectance like that of the reflection layer 40. The periphery reflection layer 42 can be formed between neighboring unit regions TA.

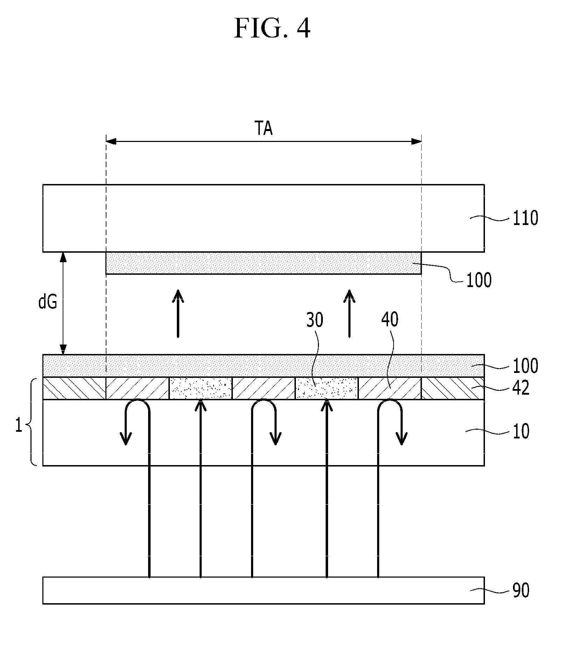

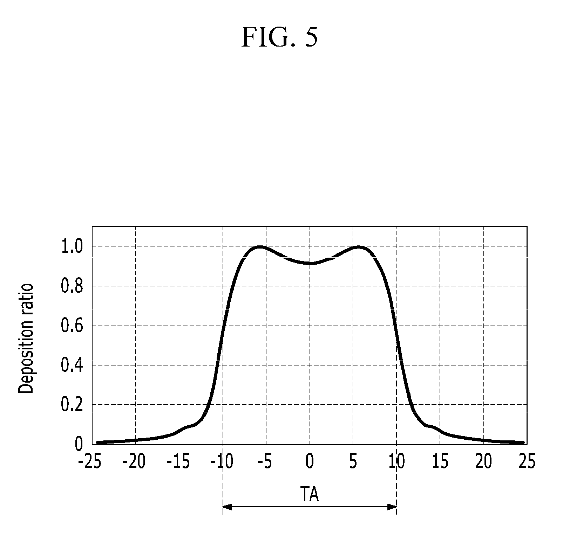

Next, a method of forming a layer using the mask 1 according to an exemplary embodiment will be described with reference to FIG. 4 and FIG. 5 as well as the previously described drawings.

FIG. 4 is a cross-sectional view of a process of forming a layer on an object substrate by using the mask for forming the layer shown in FIG. 3. FIG. 5 is a simulation graph of a thickness according to a position of a layer formed by using the mask 1 according to an exemplary embodiment.

Referring to FIG. 4, a deposition material 100 for a layer material is coated on the light absorption layer 30 and reflection layer 40 of the mask 1. The deposition material 100 can include an organic material.

A protection layer (not shown) can be formed between the deposition material 100 and both the light absorption layer 30 and reflection layer 40. The protection layer can substantially prevent a reaction among the deposition material 100, the light absorption layer 30, and the reflection layer 40. The protection layer can include a material such as a silicon oxide (SiOₓ).

Next, an object substrate 110 is substantially aligned with the mask 1 for forming the layer. A gap dG between the object substrate 110 and the deposition material layer 100 on the mask 1 can be several micrometers, for example, about 3 µm, but is not limited thereto.

Next, a light source 90 such as a flash lamp, a halogen lamp, or a laser is placed under the substrate 10. The light irradiated to the reflection layer 40 is reflected and the light irradiated to the light absorption layer 30 is converted into heat energy such that the light absorption layer 30 is heated. The light also heats the deposition material 100 formed on the light absorption portion P. Accordingly, only the deposition material 100 on or near the light absorption layer 30 can be evaporated and transferred on to the object substrate 110.

The layer formed at the region corresponding to the unit region TA of the object substrate 110 can be substantially continuously formed. The thickness of the continuous layer can be substantially uniformly formed in at least one direction.

In a typical deposition method, a deposition material is transferred by using the mask 1 only including one light absorption portion P corresponding to one unit region TA. A center portion of the deposited layer of the unit region TA is thickest and a thickness near the edge of the layer is smaller. The thickness decreases from the center to the edge such that the layer having the thickness of an approximately Gaussian distribution is formed. Accordingly, the targeted and substantially uniform thickness of the layer cannot be obtained with the thickness of the edge portion being largely shorter than that of the target thickness.

However, if the layer is formed by using the mask 1 according to an exemplary embodiment, a plurality of light absorption portions P are positioned corresponding to one unit region TA. The deposition material 100 is evaporated therefrom and is deposited on the object substrate 110 such that the layer is deposited with a shape of a plurality of Gaussian distributions substantially overlapping one another. As a result, the thickness of the layer that can be continuously formed in one unit region TA is substantially uniform in at least the horizontal direction.

FIG. 5 shows a change of a position of the object substrate 110 according to a value of a deposition ratio with respect to a target thickness of the layer deposited on the object substrate 110. In the present simulation, each unit region TA is about 20 µm. Referring to FIG. 5, the thickness of the layer formed corresponding to the unit region TA is approximately more than about 90 % of the target thickness, and the thickness of the layer on the unit region TA that is the target deposition region is substantially uniform. Also, an unnecessary portion formed outside the unit region TA of the target region is thinner than the target region.

If the layer pattern is formed by using the mask 1, the thickness of the deposition layer for the unit region TA is substantially uniform and the thickness of the layer across the region is substantially close to the target thickness, thereby obtaining the layer pattern of the desired shape and size.

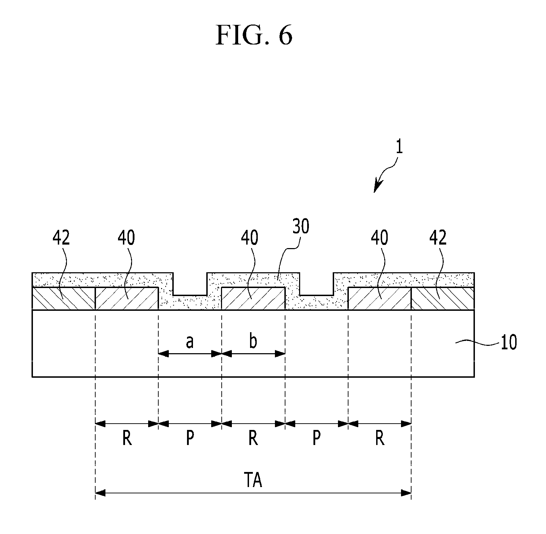

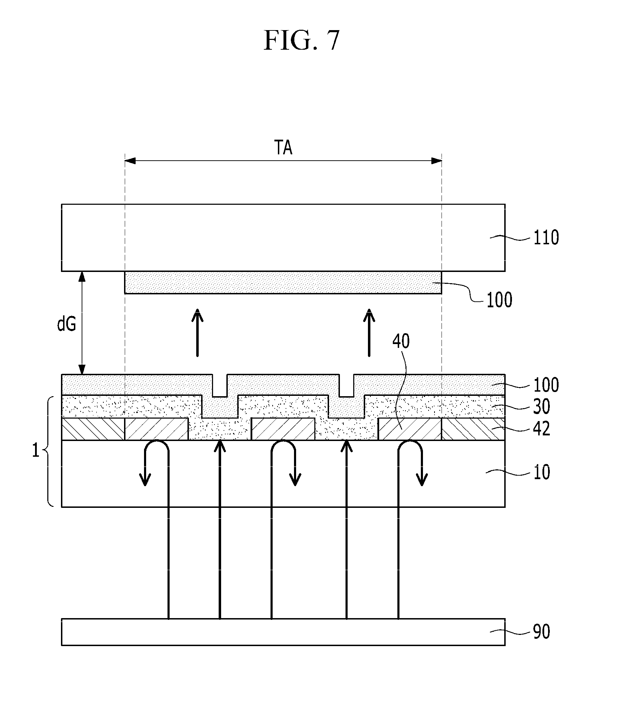

Next, the mask 1 for forming a layer and a method of forming the layer according to an exemplary embodiment will be described with reference to FIG. 6 and FIG. 7.

FIG. 6 is a cross-sectional view of the mask 1 according to an exemplary embodiment. FIG. 7 is a cross-sectional view of a process of forming the layer on a substrate by using the mask 1 shown in FIG. 6.

Referring to FIG. 6, the mask 1 according to the present exemplary embodiment is substantially similar to the exemplary embodiment shown in FIG. 1 to FIG. 3. For example, a deposition structure thereof can be different.

The reflection layer 40 is formed at a region corresponding to the reflection portion R on the substrate 10, and the light absorption layer 30 can be deposited on substantially the entire surface thereof. That is, the light absorption layer 30 can also be deposited on the reflection layer 40. The reflection layer 40 can be deposited by sputtering, deposition, plating, or patterning.

Referring to FIG. 7, a method of forming a layer using the mask 1 according to an exemplary embodiment is substantially similar to the exemplary embodiment shown in FIG. 4.

Firstly, to form the layer, the deposition material 100 is coated on the light absorption layer 30 of the mask 1. The deposition material 100 can include the organic material.

Next, the object substrate 110 for the layer to be formed is substantially aligned with the mask 1. The gap dG between the object substrate 110 and the deposition material layer 100 on the mask 1 can be several micrometers, for example, about 3 µm, but is not limited thereto.

Next, the light source 90 such as a flash lamp, a halogen lamp, or a laser configured to irradiate light is placed under the substrate 10. Next, the light irradiated to the reflection layer 40 corresponding to the reflection portion R is reflected. Only the light irradiated to the light absorption layer 30 that does not overlap the reflection layer 40 can be substantially converted into heat energy such that the light absorption layer 30 is heated. Accordingly, the deposition material 100 formed on the light absorption layer 30 is also heated. Therefore, only the deposition material 100 on or near the light absorption layer 30 can be evaporated and transferred onto the object substrate 110 to be deposited.

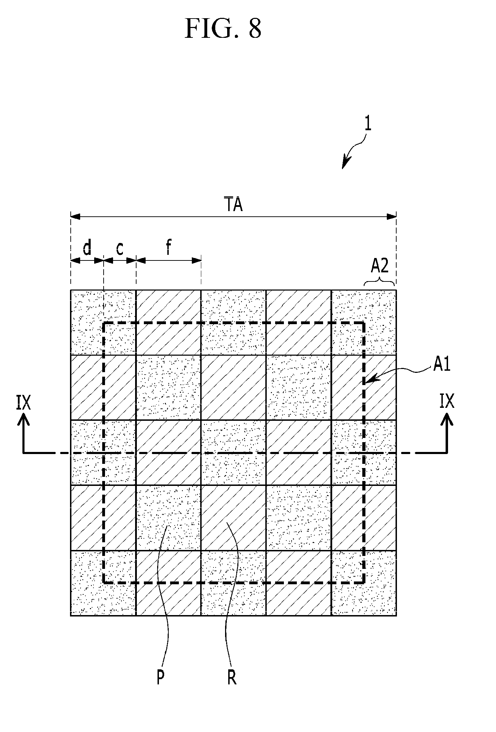

Next, the mask 1 according to an exemplary embodiment will be described with reference to FIG. 8 to FIG. 10 as well as the described drawings.

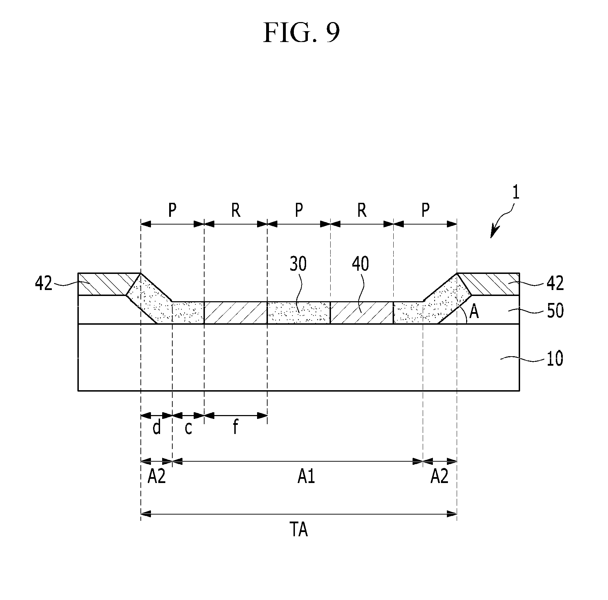

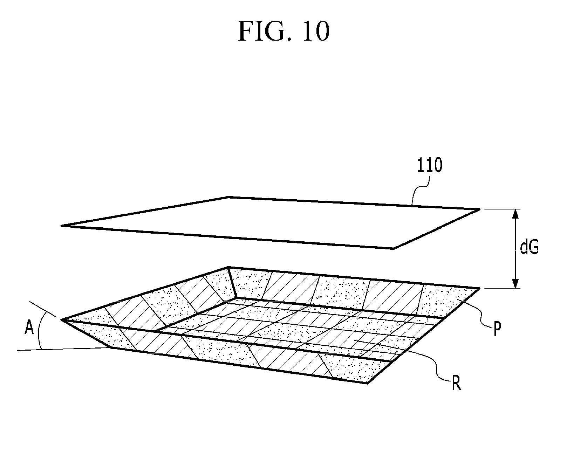

FIG. 8 is a top plan view of the mask 1 according to an exemplary embodiment, FIG. 9 is a cross-sectional view of the mask 1 shown in FIG. 8 taken along the line IX-IX. FIG. 10 is a perspective view of the mask 1 and the object substrate shown in FIG. 8.

The mask 1 according to the present exemplary embodiment is substantially similar to the exemplary embodiment shown in FIG. 1 to FIG. 3. For example, the light absorption portion P and the reflection portion R can be alternately arranged in two directions that cross each other on a 2D plane surface. That is, the mask 1 includes a plurality of light absorption portions P and a plurality of reflection portions R that are substantially alternately arranged in the horizontal direction and the vertical direction. Therefore, as shown in FIG. 8, the light absorption portions P and the reflection portions R can be formed in a checker board shape.

The width f of the light absorption portion P or the reflection portion R measured in substantially the horizontal direction and substantially the vertical direction can be in a range of several micrometers, for example, from about 2 µm to about 5 µm, but is not limited thereto.

Each of the light absorption portion P and the reflection portion R can have a substantially rectangular shape, but is not limited thereto. FIG. 8 is an example in which each of the light absorption portion P and the reflection portion R has a substantially square shape. Also, the shape of the light absorption portion P and the reflection portion R positioned at one unit region TA, as shown in FIG. 8, can be substantially uniform and can also vary.

Referring to FIG. 9, the light absorption portion P and the reflection portion R can be formed of a light absorption layer 30 and a reflection layer 40, respectively, that are alternately formed on the substrate 10. The light absorption layer 30 and the reflection layer 40 can be formed in the same layer.

Referring to FIG. 8 to FIG. 10, the light absorption layer 30 or the reflection layer 40 can be formed in at least a portion of the inclination region A2 positioned at the edge of the unit region TA. The light absorption layer 30 or the reflection layer 40 can be inclined upward with an inclination angle A with respect to the surface of the substrate 10. A layer 50, also referred to as an insertion layer 50, can be formed between the substrate 10 and both the light absorption layer 30 and reflection layer 40. The insertion layer 50 can be formed at the outer region of the unit regioin TA and can be extended outside (e.g. the environment) from the inclination region A2 formed at the edge of the unit region TA.

The thickness of the insertion layer 50 of the inclination region A2 gradually increases as it goes towards the outer region of the inclination region A2 thereby forming an inclined surface. The inclination angle A of the insertion layer 50 can be in a range from about 20 degrees to about 70 degrees. However, the inclination angle A is not limited thereto. In the inclination region A2, the inclination angle A of the insertion layer 50 can be substantially constant or changed. FIG. 9 shows an example of the inclination angle A of the insertion layer 50 being substantially constant.

The periphery reflection layer 42 can be formed at the outer region of the unit region TA. The periphery reflection layer 42, as shown in FIG. 9, can be formed on the insertion layer 50. However, the insertion layer 50 under the periphery reflection layer 42 can be omitted in another embodiment.

The inclination region A2 formed at the edge of the unit region TA, as shown in FIG. 8, can enclose the center region A1.

The width d of the inclination region A2 can be smaller than or substantially equal to the width f of the corresponding light absorption portion P or reflection portion R. In some embodiments, when the width d of the inclination region A2 is smaller than the width f of the corresponding light absorption portion P or reflection portion R, the light absorption portion P or the reflection portion R positioned at the edge of the unit region TA can be divided into a portion positioned at the inclination region A2 and a portion positioned at the center region A1. The width c of the portion positioned at the center region A1 of the light absorption portion P or the reflection portion R can be substantially equal to or different from the width d of the inclination region A2.

According to another exemplary embodiment, the insertion layer 50 can be omitted, and in this case, the light absorption layer 30 and the reflection layer 40 of the unit region TA can be substantially flat without the inclined portion.

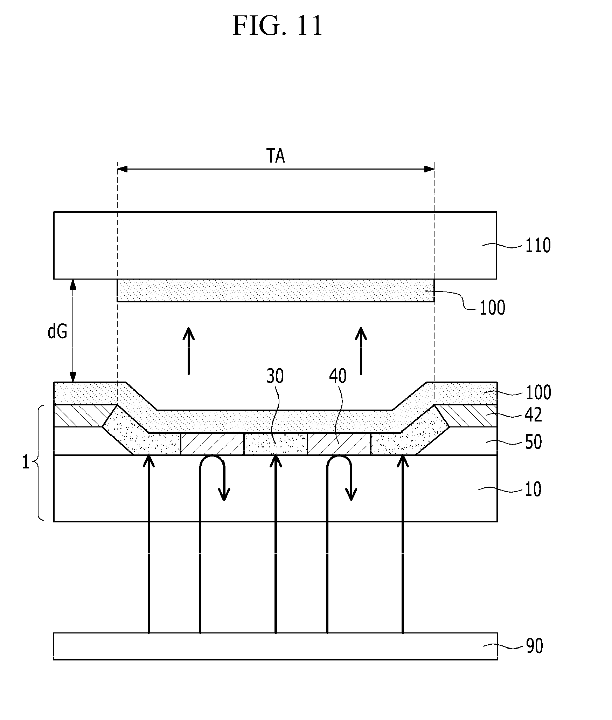

Next, a method of forming a layer using the mask for forming the layer according to an exemplary embodiment will be described with reference to FIG. 11 and FIG. 12 as well as FIG. 8 to FIG. 10.

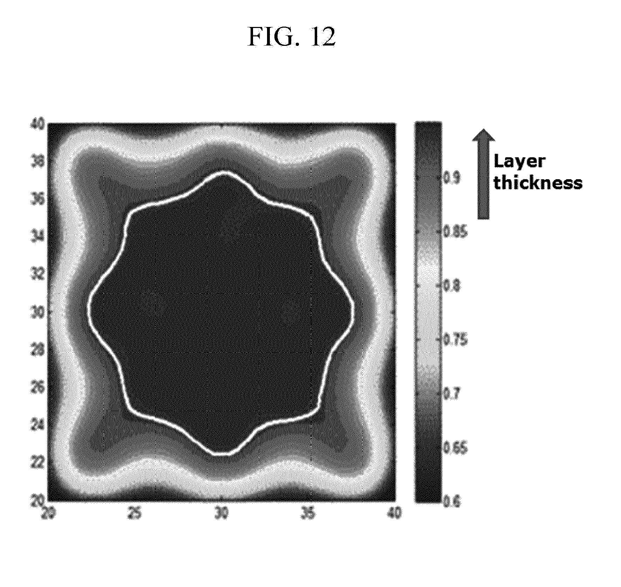

FIG. 11 is a cross-sectional view of a process of forming a layer on an object substrate by using the mask 1 shown in FIG. 9. FIG. 12 is a simulation result of a thickness of a layer formed by using the mask 1 shown in FIG. 8.

Referring to FIG. 11, the deposition material 100 for the layer material is coated on the light absorption layer 30 and the reflection layer 40 of the mask 1 according to an exemplary embodiment. The deposition material 100 can include the organic material.

A protection layer (not shown) can be formed between the deposition material 100 and both the light absorption layer 30 and reflection layer 40, to substantially prevent a reaction between the deposition material 100 and both the light absorption layer 30 and reflection layer 40. The protection layer can include a material such as a silicon oxide (SiOₓ).

Next, the object substrate 110 for the layer to be formed is substantially aligned with the mask 1 for forming the layer. A gap dG between the object substrate 110 and the deposition layer 100 on the mask 1 can be several micrometers, for example, about 3 µm, but is not limited thereto.

Next, a light source 90 such as a flash lamp, a halogen lamp, or a laser is placed under the substrate 10 of the mask 1. The light irradiated to the reflection layer 40 is reflected and the light irradiated to the light absorption layer 30 is converted into heat energy such that the light absorption layer 30 is heated. The light also heats the deposition material 100 formed on the light absorption portion P. Accordingly, only the deposition material 100 on or near the light absorption layer 30 can be evaporated and transferred to the object substrate 110.

The layer formed at the region corresponding to the unit region TA of the object substrate 110 can be continuously formed. The thickness of the layer that is continuously formed at the unit region TA can be substantially uniformly formed on the two dimensional (2D) surface.

FIG. 12 is a simulation result according to a 2D position of a deposition ratio for a target thickness of a layer deposited on the object substrate 110. Referring to FIG. 12, the thickness of the layer formed corresponding to the unit region TA is approximately more than about 90 % of the target thickness. Furthermore, the thickness of the layer can be substantially uniform in the horizontal direction and the vertical direction on the unit region TA of the target deposition region.

As described above, if the layer pattern is formed by using the mask 1 according to an exemplary embodiment, the deposition material 100 is evaporated corresponding to one unit region TA. The evaporated deposition material 100 deposited on the object substrate 110 is deposited with the shape of a plurality of substantially overlapping Gaussian distributions. Accordingly, the thickness of the layer that is continuously formed at one unit region TA can be substantially uniform on the 2D surface including the horizontal direction and the vertical direction. Furthermore, the thickness across the layer can be substantially close to the target thickness, thereby obtaining the layer pattern of the desired shape and size.

In the present exemplary embodiment, if the light absorption layer 30 or the reflection layer 40 of the inclination region A2 positioned at the edge of the unit region TA is inclined with the inclination angle A, the deposition material 100 can be concentrated and transferred to the unit region TA while being substantially prevented from being evaporated outside the unit region TA of the target region. Accordingly, the layer can be substantially prevented from being formed outside the unit region TA of the target region, the thickness of the layer of the target thickness can be substantially uniform.

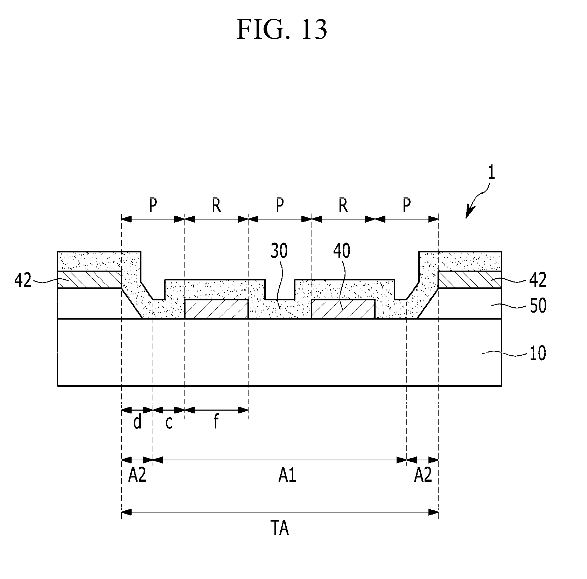

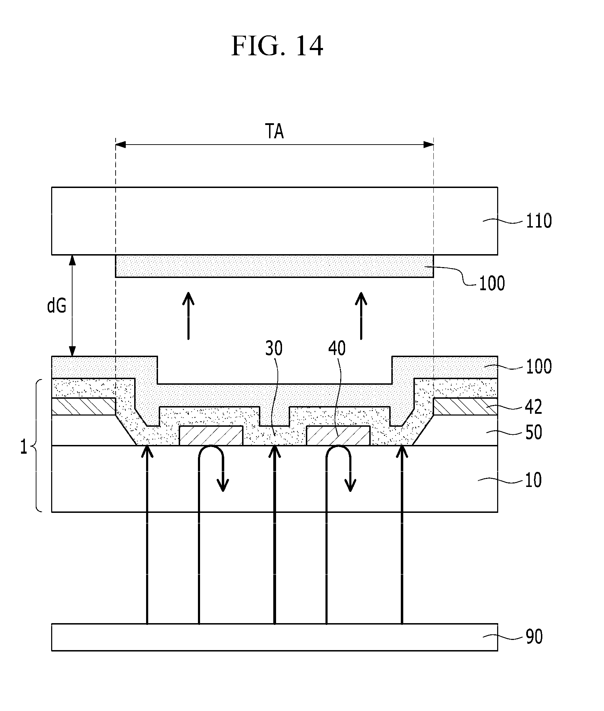

Next, the mask 1 and a method of forming a layer according to an exemplary embodiment will be described with reference to FIG. 13 and FIG. 14.

FIG. 13 is another cross-sectional view of the mask 1 of FIG. 8 taken along the line IX-IX. FIG. 14 is a cross-sectional view of a process of forming a layer on an object substrate using the mask 1 shown in FIG. 13.

Referring to FIG. 13, the mask 1 for forming a layer according to the present exemplary embodiment is substantially similar to the exemplary embodiment shown in FIG. 8 to FIG. 10 except for the deposition structure.

According to the present exemplary embodiment, the reflection layer 40 can be formed at the region corresponding to the reflection portion R on the substrate 10, and the light absorption layer 30 can be deposited on substantially the entire surface thereof. That is, the light absorption layer 30 can also be deposited on the reflection layer 40.

Referring to FIG. 14, a method of forming a layer using the mask 1 is substantially similar to the exemplary embodiment shown in FIG. 11 such that the detailed description is omitted.

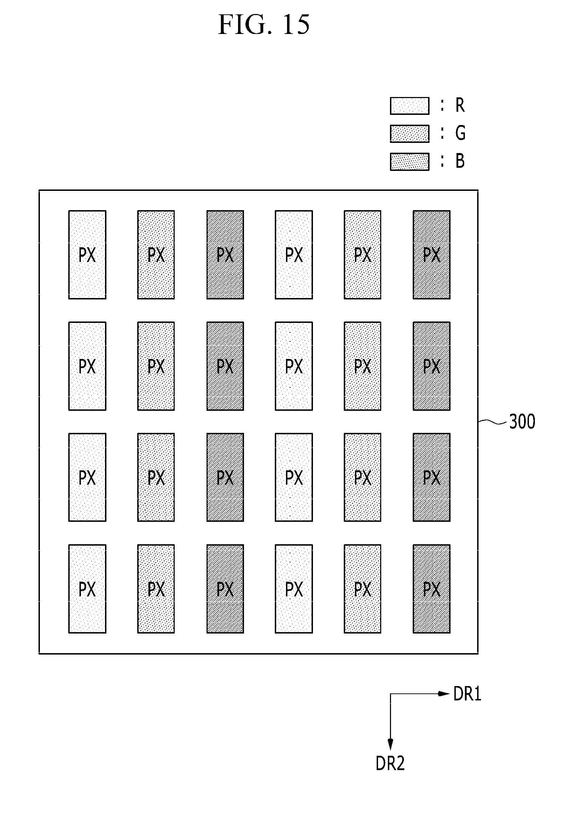

A manufacturing method of an OLED display using the mask 1 according to an exemplary embodiment will be described with reference to FIG. 15 to FIG. 17 as well as the described drawings.

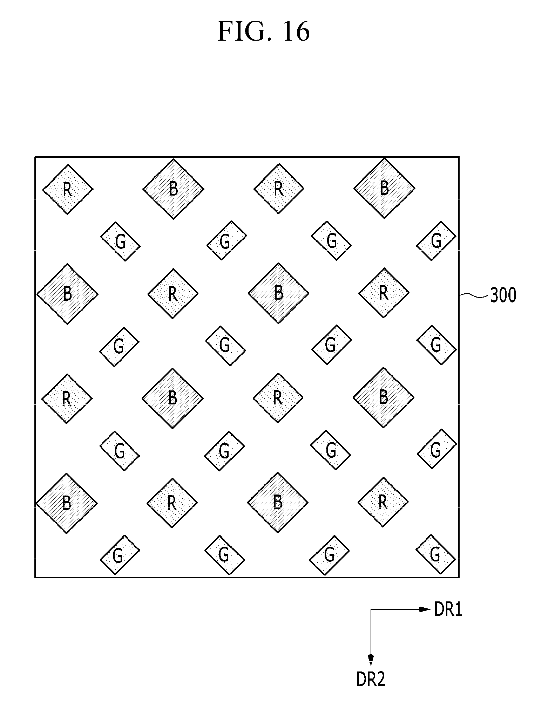

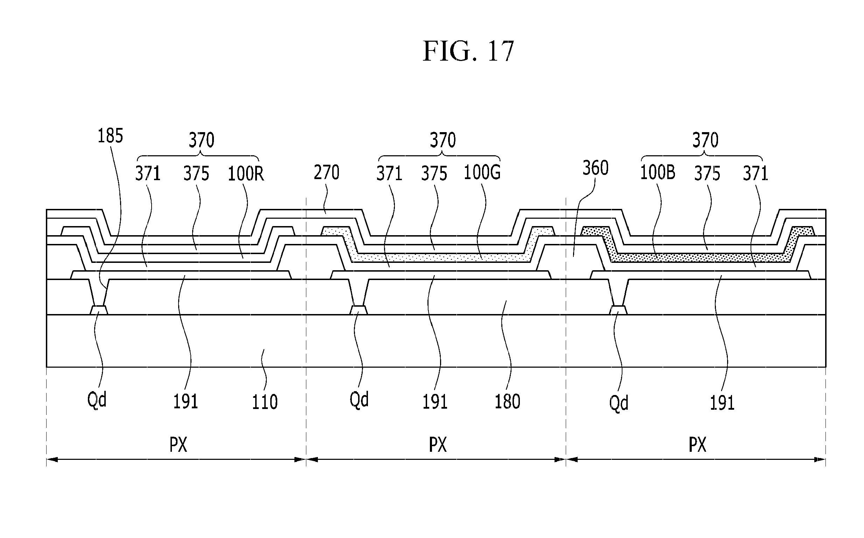

FIG. 15 and FIG. 16 are layout views of a plurality of pixels included in a display device according to an exemplary embodiment. FIG. 17 is a cross-sectional view of a display device according to an exemplary embodiment.

The display device according to an exemplary embodiment includes a display panel 300 in which a plurality of pixels PX is formed.

Firstly, referring to FIG. 15, the pixels PX can be arranged in an approximate matrix. The pixels PX arranged in a substantially horizontal direction DR1 can alternately represent different primary colors, and the pixels PX arranged in a substantially vertical direction DR2 can represent the same color.

Referring to FIG. 16, the pixels PX included in the display panel 300 according to an exemplary embodiment can be arranged in the approximate matrix that is obliquely inclined with respect to the horizontal direction DR1 or the vertical direction DR2. A plurality of signal lines (not shown) supplying signals to a thin film transistor included in the pixel PX can extend substantially parallel to the horizontal direction DR1 or the vertical direction DR2.

Each pixel PX can display one among a plurality of primary colors. In the present exemplary embodiment, the OLED display including a pixel representing red R, a pixel representing green G, and a pixel representing blue B is described. The pixels representing the different primary colors can have the same shape or size, as shown in FIG. 16, or can have a different shape and/or size to be appropriate for characteristics of the primary colors and a lifespan of the OLED. In the present exemplary embodiment, the size of the pixel representing blue (B) can be largest, and the size of the pixel representing green (G) can be smallest, but the sizes of the pixels are not limited thereto.

Each pixel can be an approximate rectangle, and particularly, the pixel representing the red R and the pixel representing the blue (B) can be rhomboid or square, but the shapes of the pixels are not limited thereto.

The pixel representing the red R and the pixel representing the green G can be alternately formed in substantially the horizontal direction DR1 or substantially the vertical direction DR2. The pixel representing the blue B and the pixel representing the green G can be alternately formed in the row or the column adjacent thereto. The pixel representing the red R and the pixel representing the blue B can be respectively adjacent to the four pixels representing the green G in a diagonal direction. Accordingly, the number of pixels representing green G is larger (for example, double) than the number of pixels representing red R or pixel representing the blue B, but is not limited thereto.

Also, the arrangement of the pixels PX can vary.

Next, a manufacturing method of a display device according to an exemplary embodiment will be described with reference to FIG. 16.

Referring to FIG. 16, the display device according to an exemplary embodiment can be an OLED display.

Firstly, an object substrate 110 including transparent glass or plastic is provided, and a plurality of signal lines (not shown) and a plurality of driving transistors Qd are formed thereon.

Next, a passivation layer 180 including an inorganic material or an organic material is deposited on the signal line and the driving transistor Qd. The passivation layer 180 is patterned to form a contact hole 185 exposing an output terminal of the driving transistor Qd.

Next, a conductive material is deposited on the passivation layer 180 by a sputtering method and patterned to form a plurality of pixel electrodes 191. Each pixel electrode 191 can be connected to the output terminal of the driving transistor Qd of each pixel PX through the contact hole 185 of the passivation layer 180.

Next, an organic material such as an acryl resin or a polyimide resin or an inorganic material such as silicon nitride is deposited and patterned on the pixel electrode 191 and the passivation layer 180 to form a pixel definition layer 360 having a plurality of openings.

Next, an emission member 370 including the organic material is formed on the pixel definition layer 360, and the pixel electrode 191 is formed by using the mask 1.

The emission member 370 can be formed by sequentially depositing a lower organic common layer 371, emission layers 100R, 100G, and 100B, and an upper organic common layer 375 in each pixel PX.

The lower organic common layer 371 can include at least one of a hole injecting layer and a hole transport layer that are sequentially deposited. The lower organic common layer 371, as shown in FIG. 16, can be formed throughout the entire surface of a display area where a plurality of pixels PX are formed, or can be formed in the groups of pixels PX.

When forming each lower organic common layer 371 in each pixel PX, the lower organic common layer 371 having substantially the uniform thickness and close to the target thickness can be formed in the target region of each pixel PX by using the mask 1. The target region to form the lower organic common layer 371 in each pixel PX corresponds to the unit region TA as described above.

The emission layers 100R, 100G, and 100B are formed on the pixel electrode 191 of the corresponding pixel PX by using the mask 1 according to an exemplary embodiment. Accordingly, the emission layers 100R, 100G, and 100B having substantially the uniform thickness while being close to the target thickness can be formed in substantially the entire region of each pixel PX. The target region to form the emission layers 100R, 100G, and 100B in each pixel PX corresponds to the unit region TA as described above.

The emission layer 100R can be made of the organic material uniquely emitting the primary color of red, the emission layer 100G can be made of the organic material uniquely emitting the primary color of green, and the emission layer 100B can be made of the organic material uniquely emitting the primary color of blue. Also, the color emitted by the emission layers 100R, 100G, and 100B can be changed.

The upper organic common layer 375 can include at least one of an electron transport layer and an electron injecting layer that are sequentially deposited. The upper organic common layer 375 can be formed throughout the entire surface of the display area where a plurality of pixels PX are formed or respectively in the region of each pixel PX in plural.

The upper organic common layer 375 having the substantially uniform thickness and close to the target thickness can be formed in the target region of each pixel PX by using the mask 1 according to an exemplary embodiment. In this example, the target region to form the upper organic common layer 375 in each pixel PX corresponds to the unit region TA as described above.

In some embodiments, when the different primary pixel colors R, G and B are alternately arranged in the two different directions on the 2D surface, and the light absorption portion P and the reflection portion R alternately arranged in two different directions on the 2D surface, the uniform layer thickness can be obtained according to at least two directions on the 2D surface. As a result, the sufficient target thickness can be substantially obtained.

The lower and upper organic common layers 371 and 375 are formed to improve emission efficiency of the emission layers 100R, 100G, and 100B. At least one of the lower and upper organic common layers 371 and 375 can be omitted.

Next, a conductive material is deposited on the emission member 370 via, for example, the sputtering method to form an opposed electrode 270 transmitting a common voltage.

The pixel electrode 191, the emission member 370, and the opposed electrode 270 form an organic light-emitting element in each pixel PX. Either the pixel electrode 191 or the opposed electrode 270 can be a cathode while the other can be an anode. For example, in some embodiment, if the pixel electrode 191 is a cathode, the opposed electrode 270 is an anode.

An encapsulation layer (not shown) substantially preventing moisture and/or oxygen from penetrating from the outside (e.g. the environment) by encapsulating the emission member 370 and the opposed electrode 270 can be formed on the opposed electrode 270.

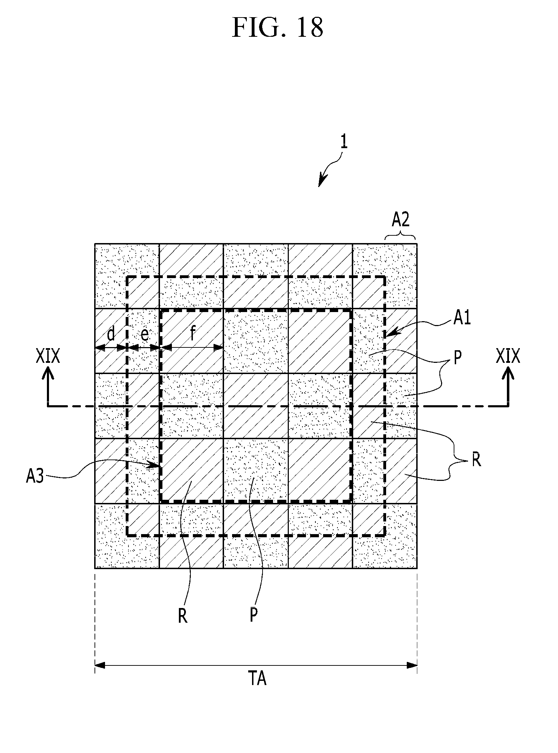

Next, the mask 1 according to an exemplary embodiment will be described with reference to FIG. 18 to FIG. 20 as well as FIG. 8 to FIG. 12.

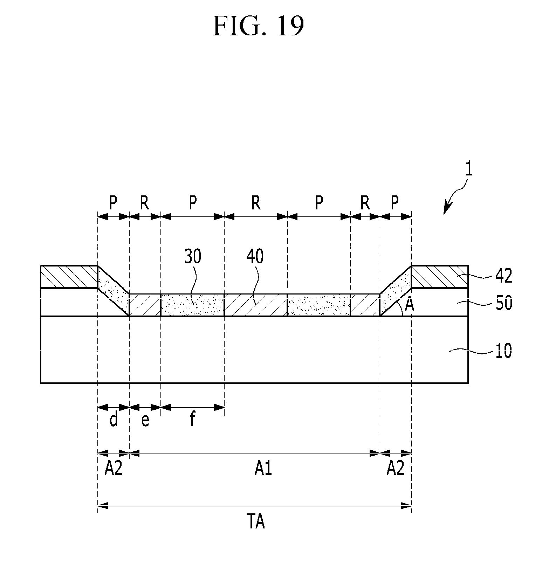

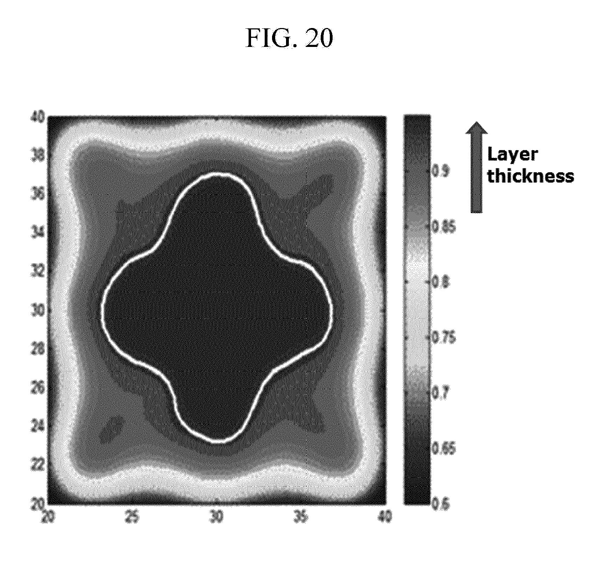

FIG. 18 is a top plan view of the mask 1 according to an exemplary embodiment. FIG. 19 is a cross-sectional view of the mask 1 of FIG. 18 taken along the line XIX-XIX. FIG. 20 is a simulation result of a thickness of a layer formed by using the mask 1 shown in FIG. 18.

Referring to FIG. 18, the mask 1 according to the present exemplary embodiment is substantially similar to the exemplary embodiment shown in FIG. 8, For example, the shape of the light absorption portion P and the reflection portion R can be different according to the position. For example, the light absorption portion P and the reflection portion R that are formed at an inner region A3 of one unit region TA are square and are approximately the same. However, the light absorption portion P and the reflection portion R positioned at the edge region outside the inner region A3 may be rectangles that are longer in the horizontal direction or the vertical direction. The light absorption portion P and the reflection portion R of the rectangle in each edge region of the unit region TA can be formed adjacent while forming two columns.

When the unit region TA is the quadrangle, the light absorption portion P or the reflection portion R can have a different shape and/or size compared to the other portions. For example, the light absorption portion P or the reflection portion R positioned at the outside of one corner can have a substantially " 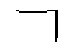 " shape or a bent shape such that the " 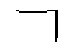 " shape is rotated, and the reflection portion R or the light absorption portion P formed inside can be approximately square. That is, a pair of a light absorption portion P and a reflection portion R adjacent to each other positioned in each corner of the unit region TA can form one quadrangle together.

The width f in the horizontal direction or the vertical direction of the light absorption portion P or the reflection portion R formed at the inner region A3 can be several micrometers For example, the width can be in a range of about 2 µm to about 5 µm, but is not limited thereto.

The widths d and e of a short side of the light absorption portion P or the reflection portion R positioned at the edge region outside the inner region A3 can be smaller than the width f of the light absorption portion P or the reflection portion R of the inner region A3. Furthermore, the sum of the widths d and e can be approximately the same as the width f. Also, the width of a long side of the light absorption portion P or the reflection portion R formed at the edge region can be almost the same as the width f.

Referring to FIG. 19, the light absorption portion P and the reflection portion R can be formed by the light absorption layer 30 and the reflection layer 40, respectively, that are alternately formed on the substrate 10. The light absorption layer 30 and the reflection layer 40 can be formed at the same layer, and substantially cannot overlap.

Referring to FIG. 18 and FIG. 19, the light absorption layer 30 or the reflection layer 40 can be inclined upward with the inclination angle A with respect to the surface of the substrate 10. The insertion layer 50 can be formed between the substrate 10 and both the light absorption layer 30 and the reflection layer 40. The insertion layer 50 extends outside from the inclination region A2.

The periphery reflection layer 42 can be formed at the outer region of the unit region TA. The periphery reflection layer 42, as shown in FIG. 9, can be formed on the insertion layer 50. However, the insertion layer 50 under the periphery reflection layer 42 can be.

The inclination region A2 positioned at the edge of the unit region TA can enclose the center region A1, as shown in FIG. 18.

The width d of the inclination region A2 can be substantially the same as the width of the corresponding light absorption portion P or reflection portion R. In this case, the inclination region A2 can be approximately aligned to the light absorption portion P or the reflection portion R of the edge region. That is, the boundary of the light absorption portion P and the reflection portion R having substantially the rectangular shape and arranged in two lines at the edge region and the outer boundary of the center region A1 can be substantially aligned to each other, but it is not limited thereto.

According to another exemplary embodiment, the insertion layer 50 can be omitted. The light absorption layer 30 and the reflection layer 40 of the unit region TA can be substantially flat without the inclination.

According to another exemplary embodiment, the reflection layer 40 of the reflection portion R and the light absorption layer 30 of the light absorption portion P can be positioned in different layers. In this embodiment, the reflection layer 40 can be formed at the region corresponding to the reflection portion R, and the light absorption layer 30 can be deposited on the entire surface thereof.

The method of forming the layer by using the mask 1 according to the exemplary embodiment shown in FIG. 18 and FIG. 19 is substantially similar to the previous exemplary embodiments.

FIG. 20 shows a simulation result according to the 2D position of the deposition ratio for the target thickness of the layer deposited by using the mask 1 according to the exemplary embodiment shown in FIG. 18 and FIG. 19 on the object substrate 110. Referring to FIG. 20, the thickness of the layer formed corresponding to the unit region TA is approximately more than about 90 % of the target thickness. Furthermore, the thickness of the layer can be substantially uniform in the horizontal direction and the vertical direction on the entire unit region TA of the target deposition region. The effect according thereto is substantially the same as described above.

The width of the light absorption portion P and the reflection portion R formed at the edge region of each unit region TA according to the present exemplary embodiment is narrower than that in the inner region A3. A repetition period of the light absorption portion P decreases, which can substantially prevent a decrease in the thickness of the layer deposited at the edge portion of the unit region TA.

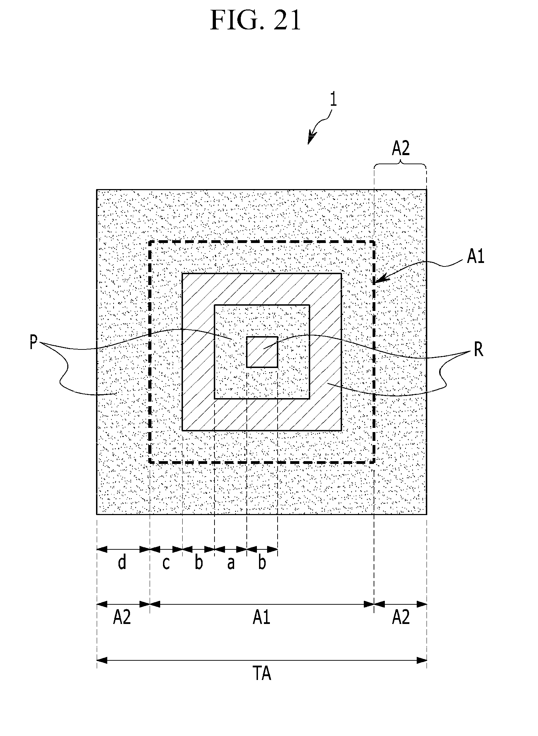

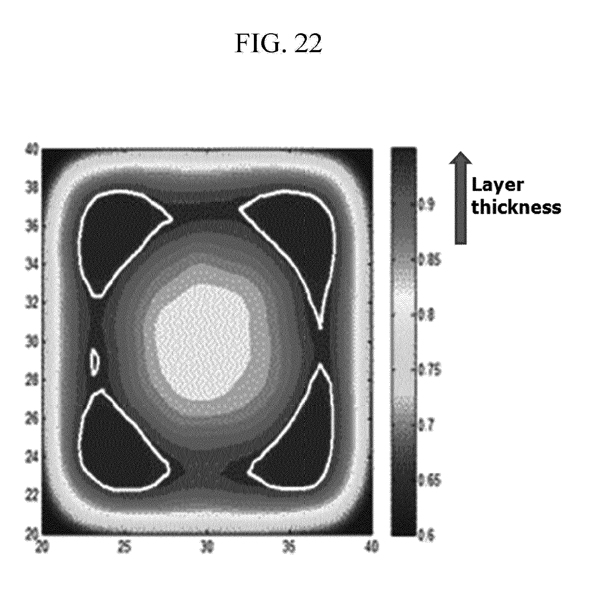

The mask 1 according to an exemplary embodiment will be described with reference to FIG. 21 and FIG. 22 as well as the described drawings.

FIG. 21 is a top plan view of the mask 1 according to an exemplary embodiment, FIG. 22 is a simulation result of a thickness of a layer formed by using the mask 1 shown in FIG. 21.

Referring to FIG. 21, the mask 1 according to the present exemplary embodiment is substantially similar to the exemplary embodiment shown in FIG. 8. For example, the shape of the light absorption portion P and the reflection portion R can be different.

According to the present exemplary embodiment, the light absorption portion P and the reflection portion R are alternately formed outwardly from the center of the unit region TA, thereby having a belt shape. For example, as shown in FIG. 21, the reflection portion R of a polygon shape, particularly a convex polygon, is formed at the center of the unit region TA. The surroundings thereof are enclosed by the light absorption portion P of a substantially square donut shape, and the surroundings thereof are again enclosed by the reflection portion R of a substantially square donut shape. This shape can be repeated in the pattern described above. The number of light absorption portions P and reflection portions R that can be repeated from the center of the unit region TA can be 1 to less than 10, for example, from 1 to 3. FIG. 21 shows an example in which the number of light absorption portions P and reflection portions R that are repeated from the center of the unit region TA is 4.

The reflection portion R formed at the center of the unit region TA can have a substantially square shape.

In other words, the mask 1 is formed with concentric square ring shapes of alternating light absorption and reflection portions.

In FIG. 21, the positions of the light absorption portion P and the reflection portion R can be exchanged.

The shapes of the light absorption portion P and the reflection portion R are not limited thereto and can be changed. For example, when the unit region TA has a circular or oval shape, the light absorption portion P and the reflection portion R can have the circular or oval shape, or the circular donut or oval donut shape.

The width a of the light absorption portion P and the width b of the reflection portion R can be constant or different according to the position. The width a of the light absorption portion P and the width b of the reflection portion R can be substantially the same or different.

The light absorption portion P or the reflection portion R can be formed at the outermost area of the unit region TA. FIG. 21 shows an example in which the light absorption portion P is formed at the outermost area of the unit region TA. The width of the light absorption portion P or the reflection portion R formed at the outermost area of the unit region TA can be respectively larger than the width a of the light absorption portion P or the width b of the reflection portion R inside.

Referring to FIG. 21, the light absorption layer forming the light absorption portion P or the reflection layer forming the reflection portion R, formed at can be inclined upwardly while having the inclination angle with respect to the surface of the substrate (not shown). The insertion layer (not shown) can be formed between the substrate, and both the light absorption layer and reflection layer. The insertion layer extends to the outside from the inclination region A2 formed at the edge of the unit region TA such that the insertion layer can be formed at the outer region of the unit region TA.

As shown in FIG. 21, the inclination region A2 formed at the edge of the unit region TA can enclose the center region A1.

The other characteristics of the insertion layer and the periphery reflection layer are substantially the same as the previously described exemplary embodiments.

The width d of the inclination region A2 can be substantially equal to or less than the width of the light absorption portion P or the reflection portion R. The light absorption portion P or the reflection portion R formed at the edge of the unit region TA can be divided into a portion formed at the inclination region A2 and a portion formed at the center region A1. The width c of the portion formed at the center region A1 of the light absorption portion P or the reflection portion R formed at the edge of the unit region TA can be substantially equal to or different from the width d of the inclination region A2.

According to another exemplary embodiment, the insertion layer for the inclination of the light absorption portion P or the reflection portion R can be omitted. The light absorption portion P and the reflection portion R of the unit region TA can be substantially flat without the inclination.

The method of forming the layer using the mask 1 according to the exemplary embodiment shown in FIG. 21 is substantially similar to at least one of the described exemplary embodiments.

FIG. 22 shows a simulation result according to the 2D position of the deposition ratio for the target thickness of the layer deposited by using the mask 1 according to the exemplary embodiment shown in FIG. 21 on the object substrate 110. Referring to FIG. 22, the thickness of the layer formed corresponding to the unit region TA is approximately more than about 90 % of the target thickness. The thickness of the layer can be substantially uniform for the horizontal direction and the vertical direction on the entire unit region TA of the target deposition region. The effect is substantially the same as described above.

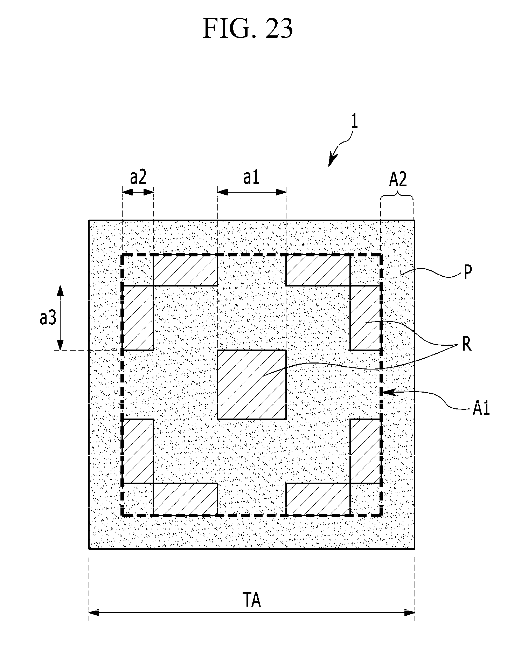

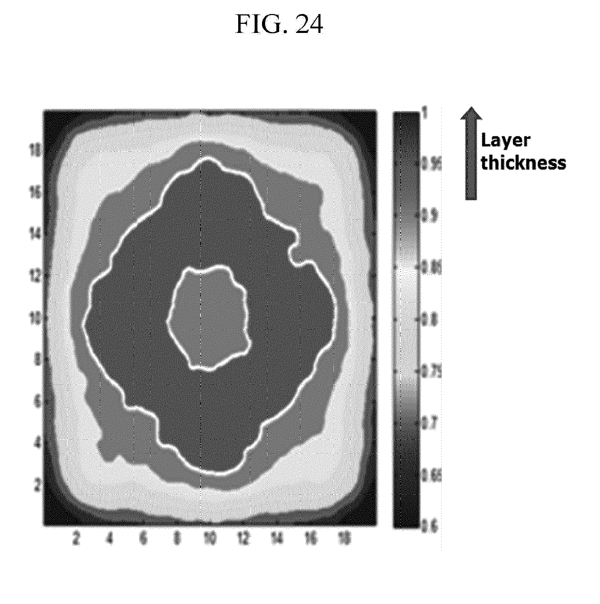

The mask 1 according to an exemplary embodiment will be described with reference to FIG. 23 and FIG. 24 as well as the described drawings.

FIG. 23 is a top plan view of the mask 1 according to an exemplary embodiment. FIG. 24 is a simulation result of a thickness of a layer formed by using the mask 1 shown in FIG. 23.

Referring to FIG. 23, the mask 1 according to the present exemplary embodiment is substantially similar to the exemplary embodiment shown in FIG. 8. For example, the shape of the light absorption portion P and the reflection portion R can be different. According to the present exemplary embodiment, the light absorption portion P or the reflection portion R is substantially entirely formed at the unit region TA, and the other portion can be formed at a partial region.

FIG. 23 shows an example in which the light absorption portion P is formed at substantially the entire unit region TA, and the reflection portion R is formed at the partial region. For example, the reflection portion R of the polygon, particularly the convex polygon, can be formed at the center of the unit region TA, and a plurality of reflection portions R separated from the reflection portion R can be formed at the surroundings thereof. The reflection portion R formed at the center of the unit region TA can have a substantially square shape. The reflection portion R formed near the center of the unit region TA can have a substantially rectangular shape, but they are not limited thereto.

For example, the length a2 of a short side of the reflection portion R formed near the center of the unit region TA can be smaller than the width a1 of the reflection portion R formed at the center of the unit region TA. The length a3 of the long side of the reflection portion R formed near the center of the unit region TA can be larger than the width a1 of the reflection portion R formed at the center of the unit region TA, but they are not limited thereto.

A plurality of reflection portions R formed near the center of the unit region TA can be formed as pairs near each corner of the unit region TA. The pair of reflection portions R formed near each corner of the unit region TA can share at least one vertex, and can be elongated in the horizontal direction and the vertical direction.

The shape and the area of the reflection portion R can vary.

Referring to FIG. 23, the light absorption layer forming the light absorption portion P or the reflection layer forming the reflection portion R, can be inclined upwardly while having the inclination angle with respect to the surface of the substrate (not shown). The insertion layer (not shown) can be formed between the substrate, and both the light absorption layer and reflection layer. The insertion layer extends outside from the inclination region A2 formed at the edge of the unit region TA such that the insertion layer can be formed at the outer region of the unit region TA.

As shown in FIG. 23, the inclination region A2 formed at the edge of the unit region TA can enclose substantially the center region A1. For example, the outer edge of the light absorption portion P near the center of the unit region TA can be substantially aligned with the boundary between the center region A1 and the inclination region A2.

In FIG. 23, the positions of the reflection portion R and the light absorption portion P can be exchanged.

According to another exemplary embodiment, the insertion layer for the inclination of the light absorption portion P or the reflection portion R can be omitted. In this case, the light absorption portion P and the reflection portion R of the unit region TA can be substantially flat without the inclination.

The method of forming the layer using the mask 1 according to the exemplary embodiment shown in FIG. 23 is substantially similar to at least one of the described exemplary embodiments.

FIG. 24 shows a simulation result according to the 2D position of the deposition ratio for the target thickness of the layer deposited by using the mask 1 for forming the layer according to the exemplary embodiment shown in FIG. 23 on the object substrate 110. Referring to FIG. 24, the thickness of the layer formed corresponding to the unit region TA is approximately more than about 90 % of the target thickness The thickness of the layer can be substantially uniform in the horizontal direction and the vertical direction on the entire unit region TA of the target deposition region. The effect is substantially the same as described above.

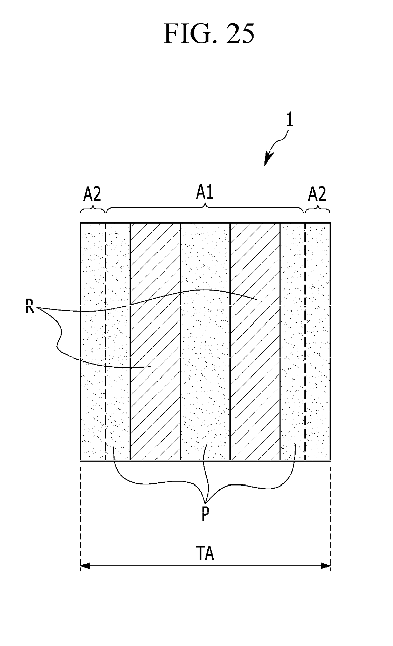

Finally, the mask 1 according to an exemplary embodiment will be described with reference to FIG. 25.

FIG. 25 is a top plan view of the mask 1 according to an exemplary embodiment.

Referring to FIG. 25, the mask 1 according to an exemplary embodiment is substantially similar to the exemplary embodiment shown in FIG. 1 or FIG. 2. For example, the light absorption layer forming the light absorption portion P or the reflection layer forming the reflection portion R formed at the right and left edges of the unit region TA can be inclined upwardly with the inclination angle with the surface of the substrate (not shown). Like the described exemplary embodiments, the insertion layer (not shown) can be formed between the substrate, and both the light absorption layer and reflection layer.

At least one of the disclosed embodiments can substantially prevent a decrease in the thickness of the layer formed at the edge of the unit region TA such that the layer having a substantially uniform thickness can be formed for the unit region TA.

While the invention has been described in connection with what are presently considered to be practical exemplary embodiments, it is to be understood that the invention is not limited to the disclosed embodiments, but, on the contrary, is intended to cover various modifications and equivalent arrangements included within the scope of the appended claims.

## Claims

1. A mask for forming a continuous layer on an object substrate, the mask comprising:
a plurality of light absorption portions; and
a plurality of light reflection portions,
wherein the light absorption portions and the light reflection portions are alternately arranged in a mask region that corresponds to a region of the object substrate at which the continuous layer is to be formed.

2. The mask of claim 1, further comprising a substrate and at least one layer formed over the substrate, the at least one layer including the light absorption portions and the light reflection portions.

3. The mask of claim 2, wherein the light absorption portions and/or light reflection portions of the layer are inclined upwards with respect to a surface of the substrate at an edge of the mask region.

4. The mask of claim 3, wherein an inclination angle of the layer is in the range of about 40 degrees to about 50 degrees.

5. The mask of claim 3 or 4, wherein the width of the inclined region of the light absorption portion or the light reflection portion of the layer is substantially equal to or less than the width of the light absorption portion or light reflection portion.

6. The mask of claim 3, 4 or 5, further comprising a second layer formed between the edge of the mask region and the substrate, wherein a surface of the second layer is inclined with respect to the substrate.

7. The mask of claim 2, wherein the light reflection portions and the light absorption portions are formed in the same layer and do not overlap each other.

8. The mask of claim 2, wherein the light reflection portions and the light absorption portions are formed in different layers, and wherein the light absorption layer includes a portion at least partially overlapping the reflection layer.

9. The mask of any one of the preceding claims, wherein at least one of the light absorption portions or the light reflection portions is substantially quadrangular.

10. The mask of claim 9, wherein the substantially quadrangular portion is substantially rectangular, includes a short side and a long side that is longer than the short side, and has a substantially square shape at a center region enclosed by the edge region in the mask region.

11. The mask of claim 10, further comprising:
a substrate;
at least one light absorption layer formed over the substrate so as to form the light absorption portion; and
at least one reflection layer formed over the substrate so as to form the light reflection portion, wherein the light absorption or reflection layer is inclined upwardly with respect to a surface of the substrate at an edge of the mask region, and wherein the length of a short side of the light absorption portion or the light reflection portion is substantially the same as the width of the inclined portion.

12. The mask of claim 1, wherein at least one of the light absorption portion or the light reflection portion comprises a series of concentric shapes enclosing the center of the mask region, wherein one of the light absorption portions and the reflection portions is formed at the center of the mask region and is substantially polygonal, wherein the width of the light absorption or reflection portion formed at an outermost area of the mask region may be larger than the width of the light absorption or reflection portion formed inside the outermost area.

13. The mask of claim 1, wherein the light reflection portions comprise a first light reflection portion formed at the center of the mask region, and a second light reflection portion separated from the first light reflection portion, wherein the second light reflection portion may be positioned adjacent to a corner of the mask region.

14. The mask of claim 13, further comprising:
a substrate;
at least one light absorption layer formed over the substrate so as to form the light absorption portions; and
at least one light reflection layer formed over the substrate so as to form the reflection portions, wherein the light absorption or reflection layer is inclined upwardly with respect to a surface of the substrate at an edge of the mask region, and wherein an inner boundary of the inclined portion is aligned with an edge boundary of the light reflection portion positioned near the center of the mask region.

15. A method of forming a continuous layer on an object substrate, comprising:
depositing a deposition material on a mask according to any one of the preceding claims;
aligning the mask with the object substrate; and
irradiating light towards a rear surface of the mask so that the light absorption portions are heated.
